(19) Europäisches Patentamt
European Patent Office
Office européen des brevets

(11) Publication number: 0 556 421 A1

(12) # EUROPEAN PATENT APPLICATION

(21) Application number: 92102673.8

(22) Date of filing: 18.02.92

(51) Int. Cl.$^5$: C08G 59/06, C08J 5/24

(43) Date of publication of application:
25.08.93 Bulletin 93/34

(84) Designated Contracting States:
AT BE CH DE ES FR GB IT LI NL SE

(71) Applicant: THE DOW CHEMICAL COMPANY
2030 Dow Center, Abbott Road
Midland, MI 48640(US)

(72) Inventor: Kishino, Yasuhiko
2-4-14, Tokura
Mishima-shi, Shizuoka-ken 411(JP)
Inventor: Ohnishi, Hideyuki
1480 Niihashi
Gotemba-shi, Shizuoka-ken 412(JP)

(74) Representative: Casalonga, Axel et al
BUREAU D.A. CASALONGA - JOSSE
Morassistrasse 8
D-80469 München (DE)

(54) **Curable resin compositions.**

(57) A curable resin composition comprising:
(A) an epoxy component containing (A-1) from 5 to 100 percent by weight of at least one epoxy resin having an average of not more than two vicinal epoxy groups per molecule and (A-2) from 95 to zero percent of at least one epoxy group having an average of more than two vicinal epoxy groups per molecule;
(B) a phenolic hydroxyl group-containing component containing (B-1) from 5 to 100 percent by weight of at least one phenolic hydroxyl-containing compound having an average of not more than two phenolic hydroxyl groups per molecule and (B-2) from 95 to zero percent by weight of at least one phenolic hydroxyl-containing compound having an average of more than two phenolic hydroxyl groups per molecule;
(C) at least one curing agent; wherein Components (A) and (B) are present in quantities which provide a ratio of epoxy groups to phenolic hydroxyl groups of from 1:0.83 to 1:0.007, is disclosed. A laminating varnish comprising the above resin composition, an electrical laminate prepared therefrom and a process for preparation of electrical laminates, are also disclosed.

EP 0 556 421 A1

The present invention relates to a novel resin composition curable with various amine curing agents, which comprises a difunctional epoxy resin and/or a polyfunctional epoxy resin, and a difunctional phenol and/or a polyfunctional phenol. The present invention also relates to a laminating varnish comprising the above resin composition, an electrical laminate prepared therefrom and a process for preparation of electrical laminate.

Heretofore, in a conventional resin system useful for preparation of printed circuit boards, brominated epoxy resins have generally been cured with dicyandiamide (DICY). Such epoxy resin compositions comprising a brominated epoxy resin and dicyandiamide have good productivity and exhibit relatively well-balanced properties when cured. Also, prepreg prepared from the epoxy resin compositions has good storage stability. However, the epoxy resin compositions show, when cured, poor heat resistance.

On the other hand, epoxy resin compositions or their cured products should meet severe requirements due to the recent need to make highly dense and highly precise electrical parts. Further, from the environmental hygiene point of view, it has been desired to reduce the amount of solvents used as much as possible. Particularly, it has been desired to reduce the amount of solvents having high boiling point such as dimethylformamide (DMF) and propyleneglycol methyl ether (PM). In view of these situations, it has been expected to provide a new epoxy resin/curing agent system.

For example, Japanese Patent Application Laid-Open Gazette No. Hei 1-153,715 (equivalent to U.S. Patent No. 4,868,059) and Japanese Patent Publication Gazette No. Sho 63-031,494 (equivalent to U.S. Patent No. 4,604,317, disclose an epoxy resin system in which an epoxy rein is cured with hydroxyl groups of a phenolic compound without use of dicyandiamide as curing agent. This epoxy resin system shows good heat resistance when cured, but shows poor adhesiveness.

In view of the deficiencies of the above-mentioned prior art, it would be desirable to provide an epoxy resin composition which has good workability and exhibits, when cured, well-balanced physical properties including moisture resistance, adhesiveness and heat resistance.

One aspect of the present invention pertains to a curable resin composition comprising:

(A) an epoxy component containing (A-1) from 5 to 100 percent by weight of at least one epoxy resin having an average of not more than two vicinal epoxy groups per molecule and (A-2) from 95 to zero percent of at least one epoxy group having an average of more than two vicinal epoxy groups per molecule;

(B) a phenolic hydroxyl group-containing component comprising (B-1) from 5 to 100 percent by weight of at least one phenolic hydroxyl-containing compound having an average of not more than two phenolic hydroxyl groups per molecule and (B-2) from 95 to zero percent by weight of at least one phenolic hydroxyl-containing compound having an average of more than two phenolic hydroxyl groups per molecule;

(C) at least one curing agent;

wherein Components (A) and (B) are present in quantities which provide a ratio of epoxy groups to phenolic hydroxyl groups of from 1:0.83 to 1:0.007.

Another aspect of the present invention pertains to a a laminating varnish comprising the above-mentioned resin composition, and at least one solvent.

A further aspect of the present invention pertains to an electrical laminate resulting from curing one or more plies of a substrate material which has been impregnated with the above-mentioned laminating varnish.

A still further aspect of the present invention pertains to a process for preparing an electrical laminate which comprises the steps of (a) impregnating a substrate with the above-mentioned curable composition; (b) heating the thus prepared prepreg; (c) fabricating the prepreg into an electrical laminate by laminating one or more layers of the prepreg with an electrical conductive material; and (d) heating the thus prepared laminate at an elevated temperature and pressure.

The present invention can provide epoxy resin compositions which have good workability and exhibit, when cured, well-balanced physical properties including moisture resistance, adhesiveness and heat resistance. The present invention makes it possible to reduce viscosity of a resin solution and to reduce amount of solvents used. Thus, due to low viscosity of the resin solution according to the present invention, impregnation into a substrate can be readily conducted. The present invention also makes it possible to reduce amount of a curing agent used (e.g., dicyandiamide) since some portion of a phenolic hydroxyl-containing component can contribute to curing.

The epoxy resin compositions can be prepared by blending the components together in any suitable manner such as, for example, mixing the two epoxy resins together in a solvent at elevated temperatures to form a uniform mixture, then cooling to room temperature and blending in the two phenolic compounds to form a uniform mixture.

Any epoxy resin having an average of more than one but not greater than two vicinal epoxy groups per molecule can be employed herein (Component (A-1)). Such suitable epoxy resins include, for example, those diglycidyl ethers of dihydric phenols represented by the formulas (I) and (II):

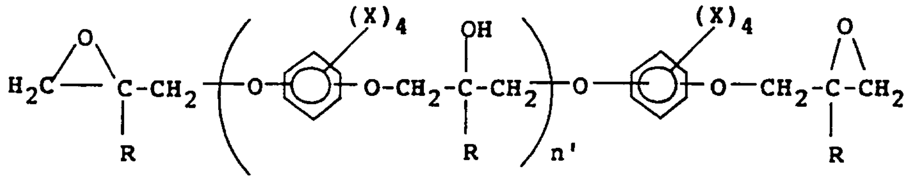

(I)

(II)

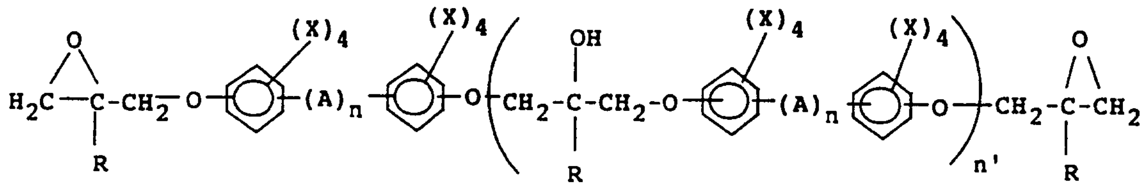

wherein each A is independently a divalent hydrocarbyl group having suitably from 1 to 10, more suitably from 1 to 5, most suitably from 1 to 3, carbon atoms, -S-, -S-S-, SO-, $-SO_2-$, -CO-, or -O-; each R is independently hydrogen or an alkyl group having from 1 to 3 carbon atoms: each X is independently hydrogen, an alkyl group having suitably from 1 to 10, more suitably from 1 to 5, most suitably from 1 to 3, carbon atoms or a halogen, preferably chlorine or bromine: each n independently has a value of zero or 1; and n' has a value suitably from zero to 10, more suitably from zero to 2, most suitably from zero to 0.5.

Particularly suitable epoxy resins having an average of more than 1 but not more than 2 vicinal epoxy groups per molecule include, for example, the diglycidyl ethers of bisphenol A, tetrabromobisphenol A where the bromine atoms are in the ortho- or meta- positions relative to the ether oxygen atoms, bisphenol K, bisphenol F, bisphenol S, bisphenol AD and mixtures thereof.

Suitable epoxy resins having an average of more than 2 vicinal epoxy groups per molecule (Component (A-2)) include, for example, those represented by the formulas (III) and (IV):

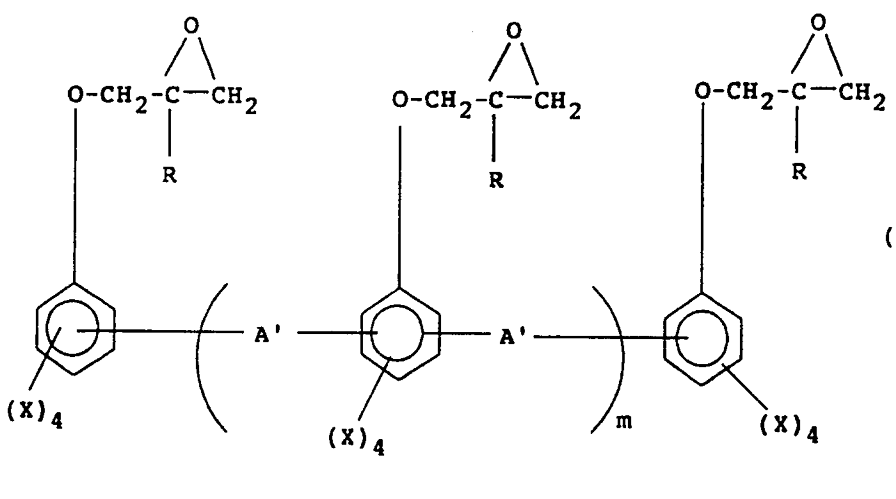

(III)

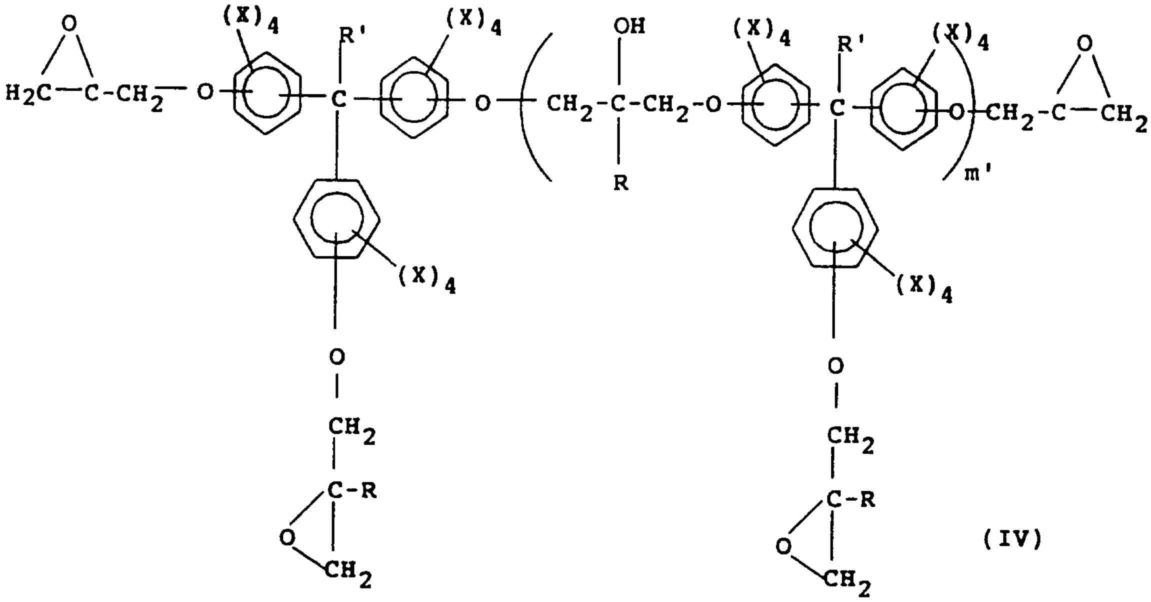

(IV)

wherein each R and X are as described above: each A' is independently a divalent hydrocarbyl group suitably having from 1 to 10, more suitably from 1 to 4, most suitably from 1 to 2, carbon atoms or a divalent polycylopentadiene group; each R' is independently hydrogen or a hydrocarbyl group having suitably from 1 to 10, more suitably from 1 to 5, most suitably from 1 to 2, carbon atoms; m suitably has a value from 0.1 to 7, more suitably from 1 to 5, most suitably from 1 to 4; and m' suitably has a value from zero to 3, more suitably from zero to 2, most suitably from zero to 1. Suitable epoxy resins having an average of more than 2 phenolic hydroxyl groups include a phenol-formaldehyde novolac epoxy resin, cresol-formaldehyde novolac epoxy resin, brominated phenol-formaldehyde novolac epoxy resin, brominated cresol-formaldehyde novolac epoxy resin, glycidylethers of trispenols and a mixture thereof.

Phenolic hydroxyl-containing compounds having an average of more than 1 but not more than 2 phenolic hydroxyl groups per molecule (Component (B-1)) include, for example, those represented by the following formulas (V) and (VI):

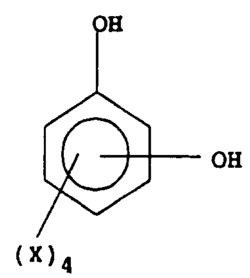

(V)

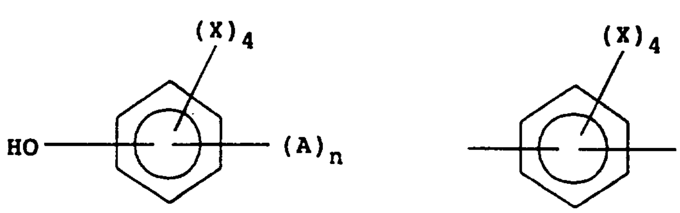

(VI)

wherein A, X and n are as previously defined. Suitable phenolic hydroxyl-containing compounds having an average of more than 1 but not more than 2 phenolic hydroxyl groups per molecule include, for example, bisphenol A, bisphenol K, bisphenol F, bisphenol S, bisphenol AD, the halogenated, particularly the brominated, derivatives of the afore-mentioned bisphenols wherein the halogen atoms are either ortho- or meta- with respect to the ether oxygen atoms, resorcinol, catechol, hydroquinone, tetramethyl-bisphenol A, 4,4'-dihydroxybiphenyl, 3,5,3'5'-tetramethyl-4,4'-dihydroxybiphenyl, 3,5,3'5'-tetrabromodihydroxybiphenyl,

3,5,3'5'-tetramethyl-2,6,2',6'-tetrabromo-4,4'-dihydroxybiphenyl and any combination thereof.

Suitable phenolic hydroxyl-containing component having an average of more than 2 phenolic hydroxyl groups per molecule (Component (A-2)) include, for example, those represented by the following formulas (VII) and (VIII):

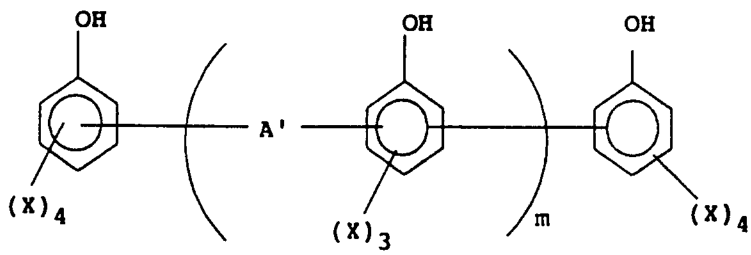

(VII)

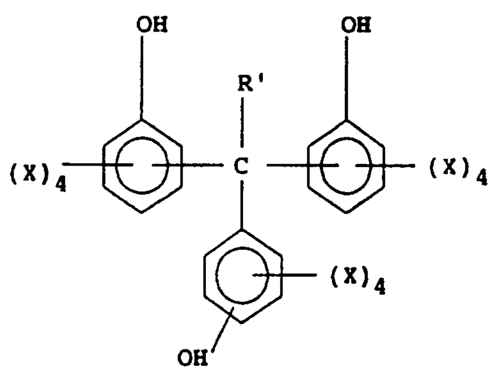

(VIII)

wherein A', R', X and m are as previously defined. Particularly suitable phenolic hydroxyl-containing compounds having an average of more than 2 phenolic hydroxyl groups per molecule include, for example, the phenol-formaldehyde novolac resins, cresol-formaldehyde novolac resins, brominated phenol-formaldehyde novolac resins, brominated cresol-formaldehyde novolac resins, 3,3',5,5'-tetramethyl-( 1,1',-biphenyl)-2,4,4'-triol, pyrogallol and any combination thereof.

In the present invention, the most suitable phenolic hydroxyl-containing compound is tetrabromobisphenol A.

The term "hydrocarbyl" as employed herein means any aliphatic, cycloaliphatic, aromatic, aryl substituted aliphatic or cycloaliphatic, or aliphatic or cycloaliphatic substituted aromatic groups.

In the present invention, the phenolic hydroxyl-containing compound (Component (B)) per se can be used as curing agent. The amount of Component (B) used can be reduced by using a small amount of the other curing agent (Component (C)). Suitable curing agents which can be used in the present invention include any known curing agents for curing epoxy resins. Particularly preferred are amine curing agents. Suitable amine curing agents include, for example, dicyandiamide, bis(4-aminophenyl)sulfone, aminophenylsulfoneamide, phenylenediamine, methylenediamine and mixtures thereof. Among these curing agents, dicyandiamide is most suitable.

The curing agents may be used in an amount of 0.001 to 10 percent by weight, more suitably 0.05 to 5 percent by weight, based on the total weight of the composition, depending upon the phenolic hydroxyl group to epoxy group ratio. If dicyandiamine is used as curing agent, depending upon the properties of the target final products, it may be used in an amount of from 0.1 to 5, more suitably from 0.1 to 3, most suitably from 1 to 2.5 percent by weight based on the total weight of the composition. In the practice of the present invention, it is preferable to use curing agents dissolved in an organic solvent having high polarity such as dimethylformamide or propylene glycol monomethyl ether, to obtain better dispersion stability.

The epoxy-containing component and the phenolic hydroxyl-containing component are employed in quantities which provide an epoxy group to phenolic hydroxyl group ratio of from 1:0.83 to 1:0.007, more suitably from 1:0.7 to 1:0.05, most suitably from 1:0.5 to 1:0.3. If the amount of the phenolic hydroxyl-containing component becomes larger, the amount of the curing agent used can be reduced, resulting in

good heat resistance and good moisture resistance. However, in this case, the adhesiveness of the resultant composition may be decreased. On the contrary, if the amount of the phenolic hydroxyl-containing component becomes smaller, the amount of the curing agent used should be increased, resulting in good adhesiveness. However, in this case, the heat resistance and the moisture resistance of the cured product may be decreased. When the epoxy group to phenolic hydroxyl group ratio is within the above-mentioned ranges, resins having well-balanced physical properties including adhesiveness, heat resistance and moisture resistance, can be obtained.

The component ratio of Component (A-1), Component (A-2), Component (B-1) and Component (B-2) may be appropriately determined in view of the targeted properties of the resultant composition. Preferably, Components (A-1) and (A-2) are used in quantities to provide a Component (A-1):Component (A-2) weight ratio of 5 to 100:0 to 95, more suitably from 5 to 95:95 to 5, most suitably from 5 to 60:95 to 40. Preferably, Components (B-1) and (B-2) are used in quantities to provide a Component (B-1):Component (B-2) weight ratio of 5 to 100:0 to 95:5, more suitably from 10 to 70:90:30, most suitably from 10 to 50:90 to 50.

In the case of using the curable composition for preparation of electric circuit boards requiring flame retardancy, the bromine content of the final cured product may be adjusted to be within a range of 15 to 40 percent by weight.

Suitable catalysts for effecting the reaction between the epoxy resin and the phenolic hydroxyl-containing compound include, for example, those disclosed in U.S. Patent Nos. 3,306,872; 3,341,580; 3,379,684; 3,477,990; 3,547,881; 3,637,590; 3,843,605; 3,948,855; 3,956,237; 4,048,141; 4,093,650; 4,131,633; 4,132,706; 4,171,420; 4,177,216; 4,302,574; 4,320,222; 4,358,578; 4,366,295; and 4,389,520.

Particularly suitable catalysts are those quaternary phosphonium and ammonium compounds such as, for example, ethyltriphenylphosphonium chloride, ethyltriphenylphosphonium bromide, ethyltriphenylphosphonium iodide, ethyltriphenylphosphonium acetate, ethyltriphenylphosphonium diacetate (ethyltriphenylphosphonium acetate•acetic acid complex), ethyltriphenylphosphonium tetrahaloborate, tetrabutylphosphonium chloride, tetrabutylphosphonium bromide, tetrabutylphosphonium iodide, tetrabutylphosphonium acetate, tetrabutylphosphonium diacetate (tetrabutylphosphonium acetate•acetic acid complex), tetrabutylphosphonium tetraholoborate. butyltriphenylphosphonium tetrabromobisphenate, butyltriphenylphosphonium bisphenate, butyltriphenylphosphonium bicarbonate, benzyltrimethylammonium chloride, benzyltrimethylammonium hydroxide, benzyltrimethylammonium tetrahaloborate, tetramethylammonium hydroxide, tetrabutylammonium hydroxide, tetrabutylammonium tetraholoborate and mixtures thereof.

Other suitable catalysts include, for example, tertiary amines such as triethylamine, tripropylamine, tributylamine and benzyldimethylamine, imidazoles such as 2-methylimidazole and mixtures thereof.

Other suitable catalysts include, for example, ammonium compounds such as triethylamine•HCl complex, triethylamine•HBr complex, triethylamine•HI complex, triethylamine•terahaloboric acid complex, tributylamine•HCl complex, tributylamine.HBr complex, tributylamine•HI complex, tributylamine•tetrahaloboric acid complex, N,N'-dimethyl-1,2-diaminoethane•tetrahaloboric acid complex and mixtures thereof.

Other suitable catalysts include quaternary and tertiary ammonium phosphonium, and arsonium adducts or complexes with suitable non-nucleophilic acids such as fluoboric, fluoarsenic, fluoantimonic, fluophosphoric, perchloric, perbromic, periodic acid and mixtures thereof.

The catalysts are employed in any quantity which will promote the reaction between the phenolic hydroxyl-containing compound and the epoxy-containing compound. Usually, a suitable quantity of catalyst is from 0.001 to 10, more suitably from 0.05 to 5 percent by weight of the total weight of the reaction mixture.

If desired, it may be desirable to include in the composition a stabilizer, pigment, dye, mold release agent, flow modifier, reinforcing material, filler, flame retardant, rubber modifier, surfactant, accelerator, reaction diluent and mixtures thereof.

Suitable stabilizers which can be used in the present invention include those represented by the following formula (IX):

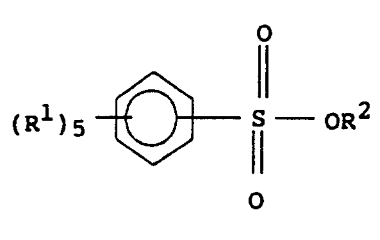

(IX)

wherein each $R^1$ is independently hydrogen, a hydrocarbyl group having 1 to 10 carbon atoms or halogen; and $R^2$ is a hydrocarbyl group having 1 to 10 carbon atoms.

Particularly suitable stabilizers include, for example, methyl p-toluene sulfonate, ethyl p-toluene sulfonate, methylchlorobenzene sulfonate and mixtures thereof. The most suitable stabilizer is methyl p-toluene sulfonate.

These stabilizers when employed, are employed in amounts to provide suitable stability, for example, from 0.001 to 10, more suitably from 0.01 to 2 percent by weight based upon the weight of the epoxy-containing component.

Suitable accelerators include the catalysts for effecting the reaction of the epoxy-containing component and the hydroxyl-containing component, as listed before.

Suitable fillers or pigments or flow modifiers include, for example, titanium dioxide, iron oxide, calcium carbonate, quartz, fused silica, silicates, silanes, metal powders such as, for example, aluminum, iron, magnesium and any combination thereof.

The epoxy resin compositions of the present invention can be suitably used for use in preparation of encapsulated electric parts and laminates for printed circuit boards.

In the preparation of laminates from the curable compositions of the present invention, the curable compositions are dissolved into one or more solvents, to obtain a laminating varnish, and applied to the substrate material from which the prepreg is to be prepared, to impregnate the laminating varnish into the substrate material.

Suitable such solvents include, for example, aromatic hydrocarbons, ketones, glycol ethers, alcohols, aliphatic hydrocarbon, cyclic ethers, halogenated hydrocarbons and amides. Particularly suitable solvents include, for example, acetone, methyl ethyl ketone, methanol, ethanol, propylene glycol methyl ether, dimethylformamide and any combination thereof. The amount of solvent which is employed is the quantity which provides the laminating varnish or other curable composition with the desired application viscosity. Usually, an amount of solvent is suitably from 1 to 75 more suitably from 1 to 50, most suitably from 1 to 25 parts by weight based upon the total weight of the laminating varnish.

Suitable substrate materials include natural and synthetic fibrous materials in filament or mat woven. Suitable fibrous materials include, fiberglass, nylon, orlon, cotton, aramid, graphite, boron, cellulose, polyethylene and polypropylene.

A varnish-impregnated substrate is dried at, for example, from 80 °C to 200 °C, preferably from 100 °C to 200 °C for 0.5 to 60 minutes, preferably 0.5 to 30 minutes to obtain half cured epoxy based prepreg.

In the preparation of electrical laminates, one or more plies of the prepreg material are pressed together at a pressure of, e.g., from 10 to 50 $Kg/cm^2$ for 0.5 to 3 hours while being heated at 130 °C to 180 °C in order to prepare a laminate therefrom. One or more layers of an electrically conductive material is employed as an outer layer of the laminate which can be one of the outer layers of the multiply prepreg materials which is pressed together under heat or the electrically conductive outer layer can be applied later by means of an adhesive. Also, if the electrical conductive layer is employed as one of the plies which is pressed together under heat, there can be, if desired, an adhesive layer placed between it and the prepreg material.

Suitable electrically conductive materials which can be employed herein include, for example the electrically conductive metals such as, aluminum, copper, gold, silver and platinum and the electrically conductive organic polymers such as polyacrylonitrile, which have been carbonated and any combination thereof.

The electrical laminates manufactured as described above can be preferably used as copper clad laminates and multi-layer printed circuit boards for electrical or electronics equipment.

The following examples are illustrative of the invention, but are not to be construed as to limiting the scope thereof in any manner.

Examples 1 to 6 - Preparation of Resin Compositions

A 2-litter flask equipped with a stirrer, cooling tube and nitrogen purge line, was charged with difunctional and/or multifunctional epoxy resins, tetrabromobisphenol A, and optionally a stabilizer at a ratio as indicated in Table 1. The kind of the epoxy components used, the phenolic component used and the catalyst used are also as shown in Table 1.

After the flask was purged with nitrogen, the reaction mixture was heated by a heating mantle to 150 °C to dissolve each component. Thereafter, methyl ethyl ketone (MEK) was added to the reaction mixture in amounts as indicated in Table 1, to cool it to room temperature.

Preparation of Laminating Varnish

A laminating varnish was prepared by mixing the epoxy resin solution as indicated in Table 1, a dicyandimaide solution (dicyandiamide/dimethylformamide/propylene glycol monomethyl ether 3/15/15) or a diaminodiphenylmethane solution (diaminodiphenylmethane/methyl ethyl ketone = 1/3) and a 2-methylimidazole solution (2-methylimidazole/methanol = 1/9) or a 2-ethyl-4-methylimidazole solution (2-ethyl-4methylimidazole/methyl ethyl ketone = 1/9) as curing agent at a ratio as indicated in Table 1. To the resultant mixture, when desired, methyl ethyl ketone was added to adjust its viscosity.

Table 1

| Kind of Resin | | Ex 1 | Ex. 2 | Ex. 3 | Ex. 4 | Ex. 5 | Ex. 6 | Comp. Ex. 1 | Comp. Ex. 2 |
|---|---|---|---|---|---|---|---|---|---|
| Liquid Epoxy Resin A | (parts) | 63.435 | 46.710 | 48.435 | 31.720 | | | | 21.660 |
| | (weight, g) | 1014.96 | 747.36 | 774.96 | 507.52 | | | | 346.560 |
| Brominated Epoxy Resin B | (parts) | | 3.973 | | | 14.488 | 1.573 | | |
| | (weight, g) | | 62.99 | | | 231.81 | 25.17 | | |
| Brominated Epoxy Resin C | (parts) | | | | | | | 125.00 | |
| | (weight, g) | | | | | | | 2000.00 | |
| Novolac Epoxy Resin D | (parts) | | 15.000 | 15.000 | | | | | |
| | (weight, g) | | 240.00 | 240.00 | | | | | |
| Multifunctional Epoxy Resin | (parts) | | | | 31.720 | | | | 21.660 |
| | (weight, g) | | | | 507.52 | | | | 346.560 |
| DCPD Epoxy Resin F | (parts) | | | | | 64.176 | 66.548 | | |
| | (weight, g) | | | | | 1026.82 | 1064.77 | | |
| TBBA | (parts) | 36.565 | 33.350 | 36.565 | 35.570 | 21.337 | 31.879 | | |
| | (weight, g) | 585.04 | 533.60 | 585.04 | 585.12 | 341.39 | 510.06 | | |
| Methylethyl Ketone | (parts) | 11.111 | 17.647 | 17.647 | 17.647 | 25.000 | 25.000 | 25.000 | 56.680 |
| | (weight, g) | 177.78 | 282.35 | 282.35 | 282.35 | 400.00 | 400.00 | 400.00 | 906.880 |
| Viscosity (cst at 25°C) | | 919 | 347 | 431 | | 589 | 714 | 2320 | 483 |
| Non-Volatiles Content (wt. %) | | 90.0 | 85.0 | 85.5 | 85.5 | 79.8 | 79.5 | 80.0 | 85.0 |
| Epoxy Resin Solution | (parts) | 111.11 | 117.65 | 116.96 | 117.65 | 125.31 | 125.79 | 125.00 | 117.68 |
| | (weight, g) | 1111.11 | 1176.47 | 1169.59 | 1176.47 | 1253.13 | 1257.86 | 1250.00 | 1176.47 |

Table 1 continued

| Kind of Resin | | Ex 1 | Ex. 2 | Ex. 3 | Ex. 4 | Ex. 5 | Ex. 6 | Comp. Ex. 1 | Comp. Ex. 2 |
|---|---|---|---|---|---|---|---|---|---|
| Amine Curing Agent Solution | (parts) | 2.19 | 3.11 | 3.13 | 2.47 | 3.11 | | 2.89 | |
| | (weight, g) | 240.90 | 342.10 | 233.97 | 271.70 | 342.10 | | 317.87 | |
| Catalyst Solution | (parts) | 0.4 | 0.2 | 0.2 | 0.1 | 0.2 | | 0.2 | 0.2 |
| | (weight, g) | 40.0 | 20.0 | 20.0 | 10.0 | 20.0 | | 20.0 | 20.0 |

Note: Epoxy Resin A is a glycydyl ether of bisphenol A (D.E.R. 331L; EEW:185).
Epoxy Resin B is a glycydyl ether of tetrab4romobisphenol A (D.E.R.™ 542; EEW:330).
Epoxy Resin C is a conventional brominated epoxy resin (D.E.R.™ 514 EK 80; EEW:485).
Epoxy Resin D is a polyglycidyl ether of a phenol-formaldehyde novolac resin (QUATREX™ 3410; EEW:199; Average Functionality: 7.0).
Epoxy Resin E is a polyblycidyl ether of a tris(hydroxyphenyl)methane novolac resin (TACTIX™ 742; EEW:160; Average Functionality: 3.0).
Epoxy Resin F is a polyglycidyl ether of a phenol-dicylopentadiene resins (EEW:250; AVERAGE FUNCTIONALITY: 3.2).
TBBA is tetrabromobisphenol A (Hydroxyl Equivalent: 272; Bromine Content: 58.8%).

D.E.R, QUATREX, and TACTIX are trademarks of The Dow Chemical Company.

The gel time (reactivity) of the varnish obtained was measured by placing the varnish on a hot plate heated to 175°C, and then measuring stroke curing time. The glass transition temperature of the resins obtained was measured by a din Pont Instrument 1090 thermal analyzer comprising a Differential Scanning Calorimeter (DSC) and a thermal mechanical analyzer (TMA), at a temperature rise rate of 10°C/min. The results are as shown in Table 2.

Preparation of Prepreg

Strips (21 cm X 24 cm) of glass cloth (7628 Type; No. 7628AS450; Manufactured by Asahi Schwebel) were manually impregnated into the varnish obtained. After impregnation, the thus impregnated strips were subjected to heat treatment in an oven heated to 165°C for 90 to 135 seconds, to obtain prepreg. In addition, the heating time (residence time in an oven) was determined by measuring the degree of cure of the prepreg by placing it on a hot plate heated to 175°C so as to set the gel time within a range of from 60 to 120 seconds.

Preparation of Laminate

The prepreg obtained under the above conditions was cut into strips having a width of 21 cm and a length of 18 cm. Eight strips of the cut prepreg were laminated, and pressed while being heated for 90 minutes. The heat-press treatment was conducted such that the final temperature was 175°C and the final press pressure was 35 $Kg/cm^2$. In addition, in some cases, a copper foil having a thickness of 35 micron meters was simultaneously laminated with the cut prepreg to measure copper peel strength.

The physical properties of the cured products were evaluated in the following manner.

Moisture Resistance

The laminates obtained were cut into small pieces (5 cm X 5 cm), and subjected to pressure cooker test in a steam saturated atmosphere, at a temperature of 121°C, at a pressure of 2 atoms for a period of 2 hours. The moisture resistance was evaluated using the following index:

$$\frac{\text{Water Pickup of Laminate After Treatment}}{\text{Water Pickup of Laminate Before Treatment}} \times 100\ (\%).$$

Heat Resistance (Solder Resistance)

After completing the pressure cooker test, solder resistance was measured by dipping three laminates for each Examples into solder heated to 260°C for 20 minutes, and then observing the surface of the treated laminates whether swelling or coming off can be seen on the laminate surface.

Adhesiveness (Copper Peel Strength)

The copper peel strength was measured in accordance with JIS C-6481.

The results of the testing are as shown in Table 2.

Comparative Example 1

The procedures of Example 1 were repeated except that a conventional brominated epoxy resin solution D.E.R.™ 514EK80; D.E.R.™ ; (Trademark of The Dow Chemical Company; supplied by Dow Chemical Japan Ltd.) having a bromine content of 21.5 percent by weight and a MEK content of 20 percent by weight, was used instead of the resin solution used in Example 1. The results are as shown in Table 2.

Comparative Example 2

The procedures of Example 1 were repeated except that a resin solution comprising a liquid epoxy resin, a multifunctional epoxy resin and methyl ethyl ketone as indicated in Table 1, was used instead of the resin solution used in Example 1. The results are as shown in Table 2.

Table 2

| Kind of Resin | Ex. 1 | Ex. 2 | Ex. 3 | Ex. 4 | Ex. 5 | Ex. 6 | Comp. Ex. 1 | Comp. Ex. 2 |
|---|---|---|---|---|---|---|---|---|
| Reactivity (Varnish) (min. at 157°C) | 160 | 223 | 201 | 160 | 172 | - | 175 | 212 |
| Glass Transition Temperature <DSC> (°C) | 135 | 146 | 144 | 172 | 178 | 178 | 128 | 145 |
| Glass Transition Temperature <TMA> (°C) | 136 | 143 | 140 | 168 | 165 | 167 | 119 | 143 |
| Water Pick Up <Pressure Cooker Test> (121°C, 2 atom, 2 hrs) | 0.40 | 0.31 | 0.29 | 0.30 | 0.12 | 0.10 | 1.47 | 0.25 |
| Solder Resistance (260°C, 20 Sec.) | 58 | 80 | 88 | 88 | 100 | 100 | 0 | 90 |
| Copper Peel Strength (Kgf/cm) | 2.2 | 1.9 | 2.0 | 1.9 | 1.8 | 1.9 | 2.3 | 1.5 |

## Claims

**1.** A curable resin composition comprising:

(A) an epoxy component containing (A-1) from 5 to 100 percent by weight of at least one epoxy resin having an average of not more than two vicinal epoxy groups per molecule and (A-2) from 95 to zero percent of at least one epoxy group having an average of more than two vicinal epoxy

groups per molecule;

(B) a phenolic hydroxyl group-containing component containing (B-1) from 5 to 100 percent by weight of at least one phenolic hydroxyl-containing compound having an average of not more than two phenolic hydroxyl groups per molecule and (B-2) from 95 to zero percent by weight of at least one phenolic hydroxyl-containing compound having an average of more than two phenolic hydroxyl groups per molecule;

(C) at least one curing agent; wherein Components (A) and (B) are present in quantities which provide a ratio of epoxy groups to phenolic hydroxyl groups of from 1:0.83 to 1:0.007.

**2.** A curable resin composition according to Claim 1, wherein Component (A-1) is a glycidyl ether of bisphenol A, bisphenol K, bisphenol F, bisphenol S, bisphenol AD, a brominated derivative thereof or a mixture thereof.

**3.** A curable resin composition according to Claim 1, wherein Component (A-2) is a phenol-formaldehyde novolac epoxy resin, a cresol-formaldehyde novolac epoxy resin, a brominated phenol-formaldehyde novolac epoxy resin, a brominated cresol-formaldehyde novolac epoxy resin or a mixture thereof.

**4.** A curable resin composition according to Claim 1, wherein Component (B-1) is bisphenol A, bisphenol K, bisphenol F, bisphenol S, bisphenol AD, a brominated derivative thereof or a mixture thereof.

**5.** A curable resin composition according to Claim 1, wherein Component (B-2) is a phenol-formaldehyde novolac resin, a cresol-formaldehyde novolac resin, a brominated phenol-formaldehyde novolac resin, a brominated cresol-formaldehyde novolac resin or a mixture thereof.

**6.** A curable resin composition according to Claim 1, wherein Component (C) is an amine curing agent selected from dicyandiamide, bis(4-aminophenyl)sulfone, aminophenylsulfoneamide, phenylenediamine, methylenediamine and a mixture thereof.

**7.** A curable resin composition according to Claim 1, wherein Components (A) and (B) are present in quantities which provide a ratio of epoxy groups to phenolic hydroxyl groups of from 1:0.7 to 1:0.05.

**8.** A laminating varnish comprising a curable resin composition according to Claim 1, and at least one solvent.

**9.** A laminating varnish according to Claim 8, wherein the solvent is acetone, methyl ethyl ketone, methanol, ethanol, propylene glycol methyl ether, dimethylformamide or a mixture thereof

**10.** An electrical laminate resulting from curing one or more plies of a substrate material which has been impregnated with a laminating varnish of Claim 8.

**11.** A process for preparing an electrical laminate which comprises the steps of (a) impregnating a substrate with an curable composition of Claim 1; (b) heating the thus prepared prepreg; (c) fabricating the prepreg into an electrical laminate by laminating one or more layers of the prepreg with an electrical conductive material; and (d) heating the thus prepared laminate at elevated temperature and pressure.

European Patent Office

# EUROPEAN SEARCH REPORT

Application Number

EP 92 10 2673

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | EP-A-0 199 292 (BASF)<br>* column 3, line 1 - line 23; claims *<br>--- | 1-11 | C08G59/06<br>C08J5/24 |
| X | EP-A-0 326 177 (MITSUBISHI RAYON CO. LTD)<br>* claims *<br>--- | 1-11 | |
| X | US-A-4 168 331 (W. DAVIS)<br>* column 2, line 49 - line 51; claims *<br>--- | 1-11 | |
| X | US-A-3 738 862 (J. M. KLARQUIST, E. A.)<br>* claims *<br>--- | 1-11 | |
| X | EP-A-0 403 022 (SHELL)<br>* claims *<br>--- | 1-11 | |
| D,A | EP-A-0 316 509 (DOW)<br>* claims *<br>--- | 1 | |
| A | US-A-4 874 669 (P.A. LARSON, E.A.)<br>* claims *<br>----- | 1 | |
| | | | TECHNICAL FIELDS SEARCHED (Int. Cl.5 ) |
| | | | C08G<br>C08J |

The present search report has been drawn up for all claims

| Place of search | Date of completion of the search | Examiner |
|---|---|---|
| THE HAGUE | 10 NOVEMBER 1992 | DERAEDT G. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document